Europäisches Patentamt

European Patent Office

Office européen des brevets

(11) Veröffentlichungsnummer: **0 197 475 B1**

(12) **EUROPÄISCHE PATENTSCHRIFT**

(45) Veröffentlichungstag der Patentschrift: **27.05.92**

(21) Anmeldenummer: **86104355.2**

(22) Anmeldetag: **29.03.86**

(51) Int. Cl.5: **H04L 25/49**

(54) **Wortweise arbeitender, multiplikativer Verwürfler und Entwürfler.**

(30) Priorität: **03.04.85 DE 3512126**

(43) Veröffentlichungstag der Anmeldung:
**15.10.86 Patentblatt 86/42**

(45) Bekanntmachung des Hinweises auf die
Patenterteilung:
**27.05.92 Patentblatt 92/22**

(84) Benannte Vertragsstaaten:
**FR GB IT**

(56) Entgegenhaltungen:
**EP-A- 0 150 862**
**DE-B- 2 634 353**
**GB-A- 1 591 805**

**ELEKTRONIK, Band 32, Nr. 26, Dezember
1983, Seiten 67-70, München, DE; T. HERMES
et al.: "Parallel arbeitende Scrambler, Descrambler und Zufallsfolgen-Generatoren"**

(73) Patentinhaber: **ANT Nachrichtentechnik GmbH
Gerberstrasse 33
W-7150 Backnang(DE)**

(72) Erfinder: **Salvasohn, Manfred, Dipl.-Ing.
Stettiner Strasse 1
W-7141 Kirchberg(DE)**
Erfinder: **Bredemeier-Klonki, Volker, Dipl.-Ing.
Karwendelstrasse 43
W-8017 Ebersberg(DE)**
Erfinder: **Kremers, Ernst, Dipl.-Ing.
Brennäckerstrasse 67
W-7157 Murrhardt(DE)**

**Beschreibung**

Die Erfindung bezieht sich auf einen wortweise arbeitenden, multiplikativen Verwürfler bzw. Entwürfler für m-Bit-breite Datenworte gemäß Oberbegriff des Patentanspruchs 1 bzw. 2. Solche Verwürfler bzw. Entwürfler sind bekannt, beispielsweise durch den Aufsatz "Realisierung von Scramblern für PCM-Signale hoher Taktfrequenz" von Möhrmann, Siemens Forschungs- und Entwicklungsbericht Band 6 von 1977 Nr. 1 Seiten 1 bis 5.

Aus dem genannten Aufsatz ist das Prinzip des multiplikativen Scramblers bzw. Descramblers entnehmbar, wobei ein rückgekoppeltes Schieberegister benutzt wird, um Quasi-Zufallsfolgen zu erzeugen, welche mit der zu verwürfelnden bzw. zu entwürfelnden Datenbitfolge verknüpft werden.

Bei hohen Übertragungsraten bzw. Schrittgeschwindigkeiten wird die Realisierung eines seriellen Scramblers bzw. Descramblers kritisch. Im selben Aufsatz ist deshalb vorgeschlagen worden, das serielle Datensignal hoher Taktfrequenz aufzuteilen in mehrere Teildatenströme, die dann einem parallelisierten Scrambler bzw. Descrambler zugeführt werden.

Die Serien-Parallel-Umwandlung einer Scambler- bzw. Descrambler-Struktur erfordert eine umfangreiche Rechenarbeit, und der Aufwand des zu realisierenden rekursiven Netzwerkes ist relativ hoch.

Aufgabe der vorliegenden Erfindung war es deshalb, eine Scrambler- bzw. Descrambler-Struktur zu finden, die einen Betrieb auch bei sehr hohen Taktfrequenzen ermöglicht und weniger Aufwand für die Realisierung mit sich bringt. Diese Struktur sollte in der Lage sein, die an moderne Scrambler und Descrambler gestellten hohen Anforderungen, die weiter unten aufgelistet werden, zu erfüllen.

Diese Aufgabe wird durch den erfindungsgemäßen Verwürfler und Entwürfler nach Anspruch 1 bzw. 2 gelöst. Optimale Ausgestaltungen ergeben sich durch die Unteransprüche.

Der erfindungsgemäße Verwürfler bzw. Entwürfler hat den Vorteil, bei wenig Aufwand für die Realisierung die Synchronisation des Empfangsdecoders einer Leitungsübertragungseinrichtung auch bei hohen Schrittgeschwindigkeiten und bei Übertragung von periodischen Signalen zu gewährleisten. Außerdem wird der Selbsttest von Coder und Decoder einer Übertragungsstrecke ermöglicht.

In dem Aufsatz "Parallel arbeitende Scrambler Descrambler und Zufallsfolgegeneratoren" in ELEKTRONIK Band 32 Nr. 26 Dez. 1983, Seiten 67 bis 70, sind multiplikative Verwürfler (Bild 4) bzw. Entwürfler (Bild 6) maximaler Länge bekanntgeworden, die einige Merkmale gemäß Oberbegriff Patentanspruch 1 bzw. 2 aber auch jeweils eine doppelte Kopplung der Schieberegisterstufen und über zwei Gatterebenen aufweisen. Dies hat die Nachteile eines mehrfachen Aufwandes für Logikschaltung und Verdrahtung sowie, daß die zweifachen Gatterebenen eine zusätzliche Laufzeit bedingen, wodurch die maximale Taktfrequenz, mit der die Schaltungen noch arbeiten können, stark begrenzt ist.

Es folgt nun die Beschreibung der Erfindung anhand der Figuren.

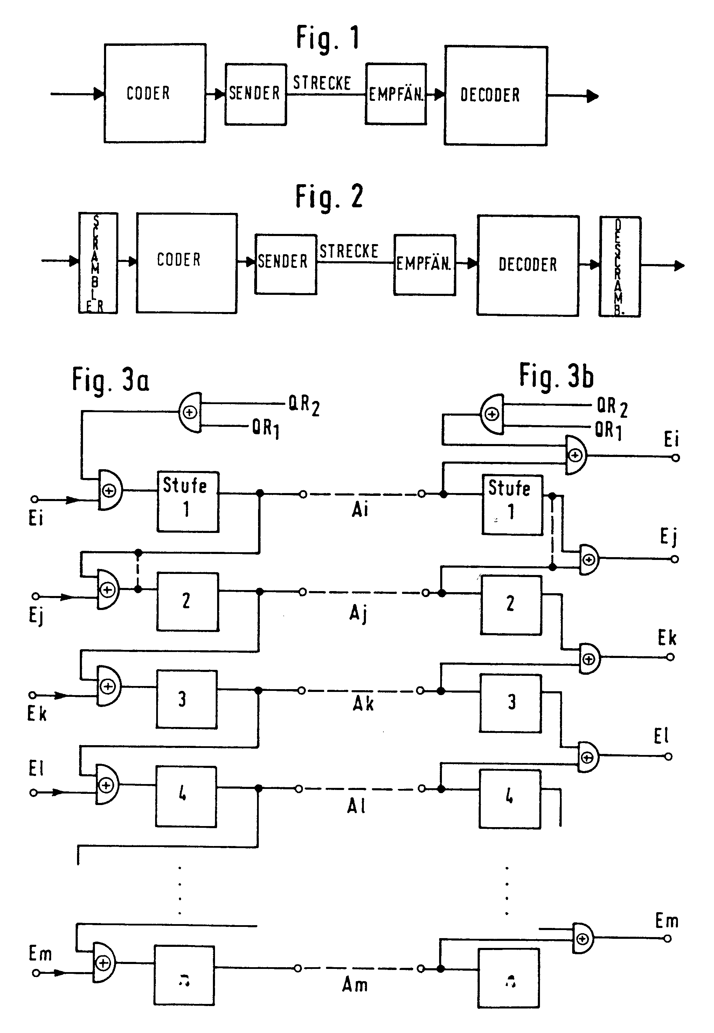

In digitalen Übertragungssystemen großer Übertragungskapazität kommt der Überwachung der Übertragungsstrecke im laufenden Betrieb besondere Bedeutung zu. Mit Hilfe von redundanten Leitungscodes ist eine derartige Überwachung möglich. Darüber hinaus kann durch geeignete Wahl des Codes die Übertragungsqualität verbessert werden. Die Figur 1 zeigt die prinzipielle Anordnung von Coder und Decoder bei einem Lichtwellenleiter-Übertragungssystem. Für die Übertragung über Lichtwellenleiter werden Blockcodes mit begrenzter laufenden digitalen Summe (LDS) eingesetzt. Fehler bei der Übertragung führen zum Überschreiten der Grenzen der LDS. Damit ist eine einfache Möglichkeit zur Fehlererkennung während des Betriebs gegeben. In der optischen Übertragungstechnik wird für die Leitungscodierung im allgemeinen ein 5B6B-Code mit einer begrenzten laufenden digitalen Summe von ±3 verwendet.

Bei der Übertragung von periodischen Signalen wie z.B. dem "Alarm Inhibit Signal" (AIS) treten Probleme bei der Synchronisation des Decoders auf. Bei bestimmten periodischen Signalen ist eine sichere Synchronisation des Decoders nicht gewährleistet, weshalb weitere Maßnahmen ergriffen werden müssen.

Die Figur 2 zeigt, wie vor dem Coder ein Verwürfler (Scrambler) und auf der Empfangsseite nach dem Decoder ein entsprechender Entwürfler (Descrambler) eingefügt ist. Ein solcher Verwürfler hat die Aufgabe, das anfallende Datensignal in ein zufallsähnliches Signal zu überführen, wobei folgende Forderungen gestellt werden müssen.

1. Durch den Scrambler soll eine Datenfolge angeboten werden, die nach der Codierung möglichst viele 1-0-Übergänge erzeugt, so daß eine günstige Taktableitung und eine gute Synchronisation ermöglicht werden.

2. Durch den Scrambler soll dem Coder ein Datensignal mit einer möglichst statistischen Folge auch dann angeboten werden, wenn am Scramblereingang das Dateneingangssignal mit Dauerlage ansteht.

3. Wenn am Dateneingang des Scramblers ein Datensignal mit einer bestimmten Dauerlage ansteht, so muß der Scrambler eine Datenfolge liefern, durch die am Coderausgang die vollständige Codetabelle erzeugt wird, dadurch ist eine vollständige Überprüfung im Selbsttest des Coders und des Decoders einschließlich der Synchronisation möglich.

4. Bei Nicht-Synchronisation des Decoders müssen möglichst viele Codeverletzungen erzeugt werden.

5. Im allgemeinen sind diese Anforderungen nur mit einem Verwürfler erreichbar, der über ein n-stufiges Schieberegister verfügt, welches derart rückgekoppelt ist, daß eine Quasi-Zufallsfolge mit maximaler Länge erzeugt wird.

Die Figur 3 zeigt eine allgemeine Scrambler-Descramblerstruktur zur Anwendung des erfindungsgemäßen Verfahrens. Die Figur 3a zeigt den Scrambler und die Figur 3b den Descrambler, wobei jeweils ein Schieberegister mit n Stufen erkennbar ist, welches über 2 Rückführungen QR1 und QR2 verfügt. Vor dem Eingang einer Stufe ist jeweils ein mod-2-Addierer eingefügt, an dessen zweitem Eingang eines der m parallelen Datensignale anliegt. Falls m < n ist, werden n-m Stufen des Schieberegisters lediglich mit der Funktion Schieben benutzt. Das betreffende mod-2-Addierglied wird dann überbrückt, siehe gestrichelte Linie in Fig. 3a und 3b bei der zweiten Stufe.

Auch der Descrambler nach Fig. 3b enthält ein Schieberegister, wobei jedoch die Vorwärts-Kopplung zwischen den einzelnen Stufen aufgetrennt und durch ein mod-2-Addierer derart ersetzt wird, daß Ausgang der vorhergehenden Stufe und Eingang der nächsten Stufe mod-2 verknüpft werden zu einem der m parallelen Signale am Ausgang des mod-2-Addierers. Es ist selbstverständlich, daß die Rückkopplung im Descrambler in genau der gleichen Weise zu erfolgen hat wie beim Scrambler. Nur dann ist gewährleistet, daß die verwürfelten parallelen Signale Ai, Aj, ... Am wieder in m parallele Signale Ei, Ej, ... Em zurückgewandelt werden, die den Eingangssignalen des Scramblers entsprechen.

Neben der hohen Verträglichkeit dieser Verwürfler-Struktur bezüglich hoher Schrittgeschwindigkeiten und der Selbstsynchronisationsfähigkeit besteht ein weiterer Vorteil darin, daß durch Vertauschen der Eingangssignale, durch Vergrößern der Stufenzahl und durch verschiedene Möglichkeiten der Rückkopplungen QR1 und QR2 viele Freiheitsgrade ermöglicht werden.

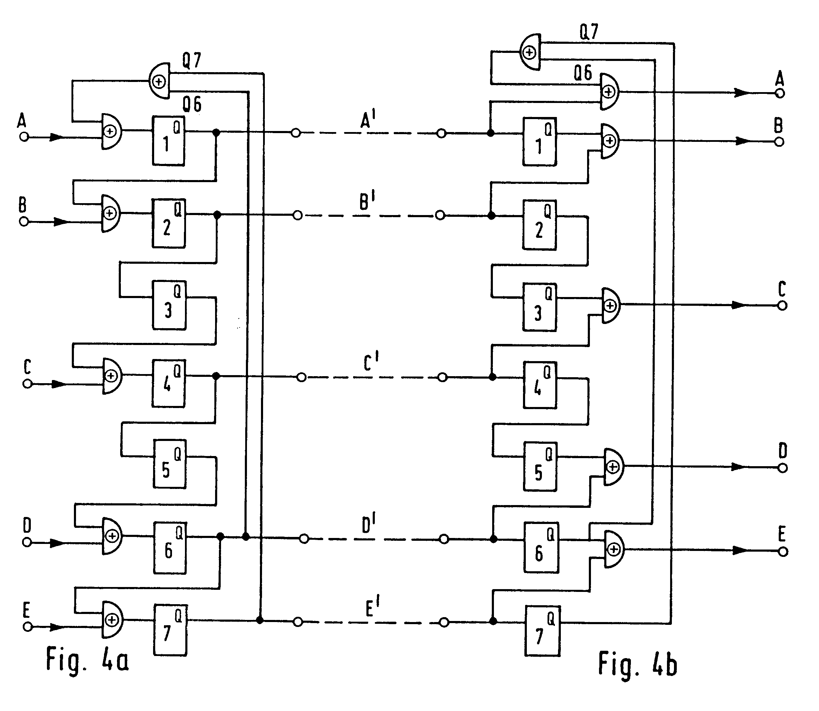

Diese Freiheitsgrade ermöglichen wiederum, spezielle Anforderungen an einen Scrambler zu stellen und zu realisieren. Der in Lichtwellenleiter-Übertragungssystemen verwendete 5B6B-Code hat die Eigenschaft, daß es viele periodische Folgen und Dauerlagen gibt, die auf der Decoderseite keine Synchronisation ermöglichen. Zu diesen Dauerlagen gehört auch die Dauerlage 1, welche das AIS-Signal darstellt. Zur Übertragung dieses Signals über Lichtwellenleiter-Übertragungssysteme werden die Verwürfler-Struktur nach Figur 4a und die Entwürfler-Struktur nach Figur 4b, welche eine Ausgestaltung der allgemeineren Struktur nach den Figuren 3a und 3b darstellt, ausgewählt. Da mit einem 5- oder 6-stufigen Scrambler am Code-Ausgang nicht alle möglichen Werte der Code-Tabelle erzeugt werden können, wenn an den Dateneingängen des Sramblers ein Signal mit Dauerlage ansteht, muß n zumindestens gleich 7 gewählt werden.

Die Tabellen 1 und 2 zeigen eine Auflistung der verschiedenen möglichen Rückkopplungen eines 7-stufigen Scramblers maximaler Länge und eine Auflistung der verschiedenen Möglichkeiten der Datenführung A, B, C, D und E, um die gestellten Anforderungen für einen 5B6B-Code nach der europäischen Patentanmeldung 64 097 zu erfüllen, wenn am Scramblereingang ein Datensignal mit der Dauerlage 1 (Tabelle 1) bzw. Dauerlage 0 (Tabelle 2) ansteht. In Ergänzung zur Tabelle 2 ist festzustellen, daß zu der Scrambler-Stuktur gemäß Zeile 1 ein entsprechender Descrambler-Aufbau gemäß Figur 3b nicht möglich ist.

Beim Scrambler nach Figur 4a werden die parallelisierten Eingangssignale A bis E den Stufen 1, 2, 4, 6 und 7 zugeführt, an deren Ausgängen die verwürfelten parallelen Signale A', B', ... E' anstehen. Die Rückkopplung erfolgt von der 6. und der 7. Stufe auf den Eingang der 1. Stufe. Die Entwürfelung erfolgt in der entsprechenden Weise, diese Struktur ist in Figur 4b gezeichnet.

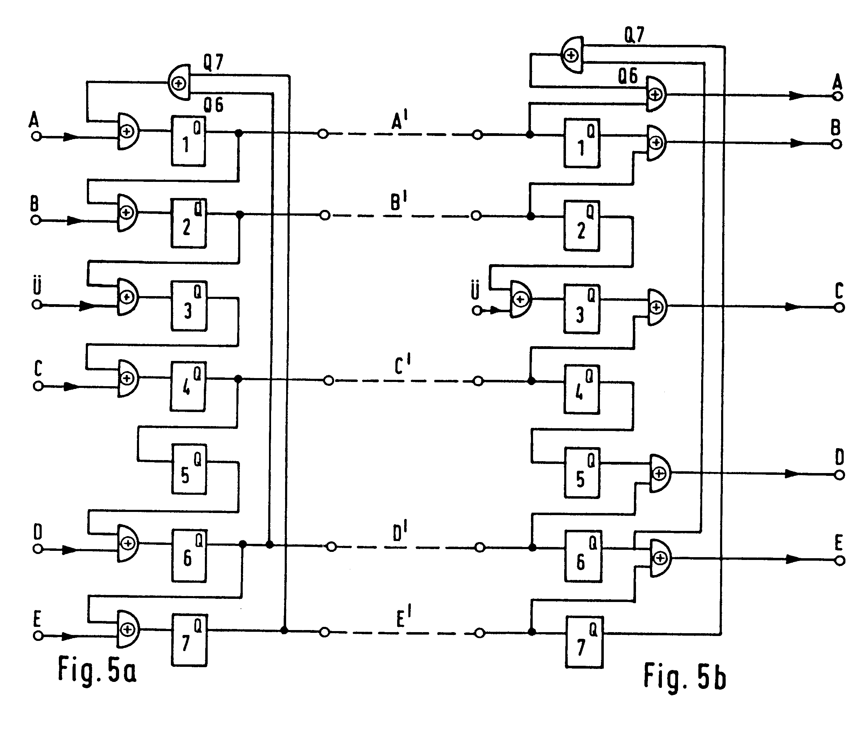

Eine weitere Ausgestaltung der Erfindung zeigt die Figur 5. Sie zeigt dieselbe Stuktur wie nach Figur 4. Zusätzlich ist jedoch eine Überwachung vorgesehen, die verhindern soll, daß der Scrambler ein periodisches Ausgangssignal liefert. In einer solchen Dauerlage befindet sich der Scrambler dann, wenn bei einer Dauerlage 0 an den Dateneingängen mit dem Scramblerinhalt 0000000 und bei der Dauerlage 1 an den Dateneingängen mit dem Scramblerinhalt 0110010 ansteht. Um diese Dauerlagen auszuschließen, werden die Scramblerinhalte auf die genannten Werte decodiert. Wird eines dieser beiden 7-Bit-Worte erkannt, so wird ein Scrambler-Bit invertiert. Besonders günstig ist es, das 3. oder das 5. Scrambler-Bit zu invertieren, da hierbei keine zusätzliche Gatterebene erforderlich ist.

In Figur 5 wurde jeweils eine Inversion der 3. Scrambler-Stufe vorgesehen, wobei im Scrambler am Eingang der 3. Stufe ein mod-2-Addierer eingefügt ist, an dessen 2. Eingang das invertierende Überwachungssignal Ü anliegt. Eine entsprechende Maßnahme ist im Descrambler nach Figur 5b vorgesehen.

Tabelle 1

| | Stufen | | | | | | Rückführung der Stufen |
| 1 | 2 | 3 | 4 | 5 | 6 | 7 | |
|---|---|---|---|---|---|---|---|
| | A | B | C | D | | E | 3,7 |
| A | | | B | C | D | E | 3,7 |
| A | | B | C | D | | E | 3,7 |
| A | B | C | D | | E | | 3,7 |
| A | B | | C | | D | E | 4,7 |
| | A | B | C | | D | E | 6,7 |
| A | B | | C | | D | E | 6,7 |
| A | B | C | | D | E | | 6,7 |

4

Tabelle 2

| Stufen | | | | | | | Rückführung der Stufen |
|---|---|---|---|---|---|---|---|
| 1 | 2 | 3 | 4 | 5 | 6 | 7 | |
| | A | B | C | D | | E | 1,7 |
| A | B | C | | D | | E | 1,7 |
| A | B | C | D | | E | | 1,7 |
| | A | B | | C | D | E | 3,7 |
| | A | B | C | | D | E | 3,7 |
| A | | B | C | | D | E | 3,7 |
| A | B | | C | D | E | | 3,7 |
| A | B | C | | D | | E | 3,7 |
| A | B | C | | D | E | | 3,7 |
| A | | B | | C | D | E | 4,7 |
| A | B | C | D | | | E | 4,7 |
| A | | | B | C | D | E | 6,7 |

**Patentansprüche**

1. Wortweise parallel arbeitender, multiplikativer Verwürfler für m-Bit-breite Datenworte, mit einem n-stufigen,
   rückgekoppelten Schieberegister, dem eine einzige m Gatter breite EXOR-Stufe zur parallelen Verknüpfung des jeweiligen Datenwortes mit dem Schieberegisterinhalt vorgeschaltet ist, wobei n ≧ m ist, wobei an dem ersten Gatter der EXOR-Stufe das erste Datenbit (Ei) und der Ausgang eines weiteren EXOR-Gatters anliegen, auf dessen Eingänge zur Rückkopplung des Schieberegisters (Stufe 1, 2, 3 ... n) die Ausgänge (QR1, QR2) von mindestens zwei Stufen geführt sind, dadurch gekennzeichnet,
   daß an den folgenden Gattern der EXOR-Stufe das jeweils folgende Datenbit (Ej, Ek, E1 ... Em) und der Ausgang der jeweils vorangehenden Schieberegisterstufe (1, 2, 3, ... n-1) anliegen und
   daß an den Ausgängen der Schieberegisterstufen (1, 2, 3, 4, ... n), deren Eingänge jeweils mit den m Gatterausgängen der EXOR-Stufe bzw. mit den Ausgängen der vorangehenden Schieberegisterstufen verbunden sind, das m-Bit-breite (Ai, Aj, Ak, Al, ... Am) verwürfelte Datenwort ansteht (Fig. 3a).

**2.** Wortweise parallel arbeitender, multiplikativer Entwürfler für m-Bit-breite, verwürfelte Datenworte, mit einem n-stufigen, rückgekoppelten Schieberegister, dem eine einzige m Gatter breite EXOR-Stufe zur parallelen Verknüpfung des jeweiligen verwürfelten Datenwortes mit dem Schieberegisterinhalt nachgeschaltet ist, wobei $m \leq n$ ist, wobei an dem ersten Gatter der EXOR-Stufe das erste Datenbit (Ai) und der Ausgang eines weiteren EXOR-Gatters anliegen, an dessen Eingängen als Rückkopplung die Ausgänge (QR1, QR2) von mindestens zwei Schieberegisterstufen liegen, dadurch gekennzeichnet, daß an den folgenden Gattern der EXOR-Stufe das jeweils folgende Datenbit (Aj, AK ... Am) und der Ausgang der jeweils vorangehenden Schieberegisterstufe anliegen, daß die einzelnen Bits (Ai, Aj, Ak, ... Am) des verwürfelten Datenworts jeweils an die Eingänge von m Schieberegisterstufen (1, 2, 3, ... n) angelegt sind, daß jeder nicht auf ein Gatter der EXOR-Stufe gelegte Ausgang einer Schieberegisterstufe mit dem Eingang der nachfolgenden Schieberegisterstufe verbunden ist und daß an den Ausgängen der EXOR-Stufe die einzelnen Bits (Ei, Ej, Ek ... Em) des entwürfelten Datenworts anstehen (Fig. 3b).

**3.** Verwürfler nach Anspruch 1, dadurch gekennzeichnet, daß m = 5 und n = 7 ist, daß die Ausgänge (Q6, Q7) der 6. und 7. Schieberegisterstufe auf die Eingänge des weiteren EXOR-Gatters geführt sind und daß die Gatterausgänge der EXOR-Stufe mit den Eingängen der 1., 2., 4., 6. und 7. Schieberegisterstufe verbunden sind (Fig. 4a).

**4.** Entwürfler nach Anspruch 2, dadurch gekennzeichnet, daß m = 5 und n = 7 ist, daß die Ausgänge der 6. und 7. Schieberegisterstufe (Q6, Q7) auf die Eingänge des weiteren EXOR-Gatters geführt sind und daß die Ausgänge (Q1, Q2, Q4, Q6, Q7) der 1., 2., 4., 6. und 7. Schieberegisterstufe mit den Gattern der EXOR-Stufe verbunden sind (Fig. 4b).

**5.** Schaltungsanordnung nach Anspruch 3 oder 4, dadurch gekennzeichnet, daß mit dem Eingang einer der Schieberegisterstufen (3), denen kein Datenbit zugeordnet ist, der Ausgang eines zusätzlichen EXOR-Gatters verbunden ist, an dessen zwei Eingängen der Ausgang der vorangehenden Schieberegisterstufe (2) und ein Überwachungssignal (Ü) liegt, dessen Pegel bei einem Schieberegisterinhalt 0 00 00 00 oder 0 11 00 10 eine Invertierung des anstehenden Bits (Q3) bewirkt (Fig. 5a, 5b).

## Claims

**1.** Multiplication scrambler operating in parallel mode word by word for data words having a width of m bits, with an n-stage shift register which is provided with feedback and connected behind a single EXOR stage having a width of m gates for the parallel interlinking of the respective data word with the shift register content, wherein n is at least equal to m, wherein the first data bit (Ei) and the output of a further EXOR gate, to the inputs of which the outputs (QR1, QR2) of at least two stages are led for the feedback of the shift register (stages 1, 2, 3 ... n), are present at the first gate of the EXOR stage, characterised thereby, that the respective following data bit (Ej, Ek, E1 ... Em) and the output of the respective preceding shift register stage (1, 2, 3 ... n-1) are present at the following gates of the EXOR stage and that the scrambled data word having a width of m bits (Ai, Aj, Ak, Al ... Am) is present at the outputs of the shift register stages (1, 2, 3, 4 ... n), the inputs of which are respectively connected with the m gate outputs of the EXOR stage or with the outputs of the preceding shift register stages (Figure 3a).

**2.** Multiplicative unscrambler operating in parallel mode word by word for scrambled data words having a width of m bits, with an n-stage shift register which is provided with feedback and connected in front of a single EXOR stage having a width of m gates for the parallel interlinking of the respective scrambled data word with the shift register content, wherein m is at most equal to n, wherein the first data bit (Ai) and the output of a further EXOR gate, at the inputs of which the outputs (QR1, QR2) of at least two shift register stages are present as feedback, are present at the first gate of the EXOR stage, characterised thereby, that the respective following data bit (Aj, Ak ., Am) and the output of the respective preceding shift register stage are present at the following gates of the EXOR stage, that the individual bits (Ai, Aj, Ak ... Am) of the scrambled data word are each applied to respective inputs of m shift register stages (1, 2, 3 ... m), that each output of a shift register stage not applied to a gate of the EXOR stage is connected with the input of the following shift register stage and that the individual bits (Ei, Ej, Ek ... Em) of the unscrambled data word are present at the outputs of the EXOR stage (Figure 3b).

3. Scrambler according to claim 1, characterised thereby, that m is equal to 5 and n is equal to 7, that the outputs (Q6, Q7) of the sixth and seventh shift register stages are led to the inputs of the further EXOR gate and that the gate outputs of the EXOR stage are connected with the inputs of the first, second, fourth , sixth and seventh shift register stages (Figure 4a).

4. Unscrambler according to claim 2, characterised thereby, that m is equal to 5 and n is equal to 7, that the outputs of the sixth and seventh shift register stages (Q6, Q7) are led to the inputs of the further EXOR gate and that the outputs (Q1, Q2, Q4, Q6, Q7) of the first, second, fourth, sixth and seventh shift register stages are connected with the gates of the EXOR stage (Figure 4b).

5. Circuit arrangement according to claim 3 or 4, characterised thereby, that the input of one of the shift register stages (3), with which no data bit is associated, is connected with the output of an additional EXOR gate, to the two inputs of which is applied the output of the preceding shift register stage (2) and a monitoring signal (Ü), the level of which causes an inversion of the bit (Q3) present in the case of a shift register content of 0 00 00 00 or 0 11 00 10 (Figures 5a and 5b).

**Revendications**

1. Embrouilleur multiplicatif, travaillant en parallèle par mots, pour des mots de données de m bits de largeur, avec un registre à décalage de n étages à réaction, précédé d'un seul étage OU exclusif de m portes de largeur pour l'injection en parallèle du mot de données dans le registre à décalage, n étant égal ou supérieur à m, où la première porte de l'étage OU exclusif reçoit le premier bit de données (Ei) ainsi que la sortie d'une autre porte OU exclusif dont les entrées, aux fins de réaction du registre à décalage (étages 1, 2, 3,... n) reçoivent les sorties (QR1, QR2) d'au moins deux étages, caractérisé en ce que les portes suivantes de l'étage OU exclusif reçoivent chacune le bit de données suivant (Ej, Ek, El, ... Em) et la sortie de l'étage précédent du registre à décalage (1, 2, 3, ... n-1) et en ce que les sorties des étages du registre à décalage (1, 2, 3, 4, ... n), dont les entrées sont reliées aux sorties des m portes de l'étage OU exclusif ou aux sorties des étages précédents du registre à décalage, fournissent le mot de données embrouillé d'une largeur de m bits (Ai, Aj, Ak, ... Am) (figure 3a).

2. Désembrouilleur multiplicatif, travaillant en parallèle par mots, pour des mots de données embrouillés de m bits de largeur, avec un registre à décalage de n étages à réaction, suivi d'un seul étage OU exclusif de m portes de largeur pour l'injection en parallèle du mot de données embrouillé dans le registre à décalage, m étant inférieur ou égal à n, où la première porte de l'étage OU exclusif reçoit le premier bit de données (Ai) ainsi que la sortie d'une autre porte OU exclusif dont les entrées, aux fins de réaction, reçoivent les sorties (QR1, QR2) d'au moins deux étages du registre à décalage, caractérisé en ce que les portes suivantes de l'étage OU exclusif reçoivent chacune le bit de données suivant (Aj, Ak, ... Am) et la sortie de l'étage précédent du registre à décalage, en ce que les différents bits (Ai, Aj, Ak, ... Am) du mot de données embrouillé sont injectés aux entrées de m étages du registre à décalage (1, 2, 3, ... n), en ce que chacune des sorties des étages du registre à décalage qui ne sont pas reliées à une porte de l'étage OU exclusif est reliée à l'entrée de l'étage suivant du registre à décalage et en ce que les sorties de l'étage OU exclusif fournissent les différents bits (Ei, Ej, Ek, ... Em) du mot de données désembrouillé d'une largeur de m bits (Ai, Aj, Ak, ... Am) (figure 3a).

3. Embrouilleur selon la revendication 1, caractérisé en ce que l'on a m = 5 et n = 7, en ce que les sorties (Q6, Q7) du 6ème et du 7ème étages du registre à décalage sont ramenées aux entrées de la porte OU exclusif suivante et en ce que les sorties des portes de l'étage OU exclusif sont reliées aux entrées des 1er, 2ème, 4ème, 6ème et 7ème étages du registre à décalage (figure 4a).

4. Désembrouilleur selon la revendication 2, caractérisé en ce que l'on a m = 5 et n = 7, en ce que les sorties des 6ème et 7ème étages du registre à décalage (Q6, Q7) sont reliées aux entrées de la porte OU exclusif suivante et en ce que les sorties (Q1, Q2, Q4, Q6, Q7) des 1er, 2ème, 4ème, 6ème et 7ème étages du registre à décalage sont reliées aux portes de l'étage OU exclusif (figure 4b).

**5.** Montage selon la revendication 3 ou 4, caractérisé en ce que l'entrée d'un des étages du registre à décalage (3) ne recevant pas de bit de données reçoit la sortie d'une porte OU exclusif supplémentaire dont les deux entrées reçoivent la sortie de l'étage précédent (2) du registre à décalage ainsi qu'un signal de surveillance (Ü) dont le niveau provoque une inversion du bit produit (Q3) lorsque le contenu du registre à décalage est 0 00 00 00 ou 0 11 00 10 (figures 5a, 5b).

# Fig. 1

# Fig. 2

# Fig. 3a

# Fig. 3b

Fig. 4b

Fig. 4a

Fig. 5a

Fig. 5b